# EUROPEAN PATENT APPLICATION

(11) **EP 2 866 399 A1**
(43) Date of publication of application: **29.04.2015**
(21) Application number: 13306452.7
(22) Date of filing: 22.10.2013
(51) Int. Cl.: H04L 25/02, G06F 13/40, H03K 19/00, H04B 3/32

(54) **Transmit circuitry and method for transmitting a signal**

(71) Applicant: ALCATEL LUCENT, 92100 Boulogne-Billancourt (FR)
(72) Inventor: Troch, Wim, 2018 Antwerpen (BE)
(74) Representative: D'Halleweyn, Nele Veerle Trees Gertrudis

(57) **Abstract**

A transmit circuitry for transmitting data between a distribution point unit and an end-user device, comprising a line driver configured for amplifying a data signal to be transmitted over a copper pair between said distribution point unit and said end-user device; an input for receiving a signal for setting said line driver in a power-up mode or a power-down mode; a controllable impedance regulator adapted for regulating an output impedance of the transmit circuitry seen by the copper pair; wherein said controllable impedance regulator is further arranged for being controlled by said input in order to regulate said output impedance when the line driver is in the power-down mode.

## Description

### Field of Invention

The field of the invention relates to transmit circuitry and transmit methods. Particular embodiments relate to the field of data transmission in G.fast transceivers.

### Background

G.fast transceivers operate in time domain duplex (TDD) which request different trade-offs and design choices in the analogue front-end compared to legacy xDSL front-ends (VDSL2, ADSLx) which is frequency domain duplex (FDD). In addition, G.fast transceivers can operate in discontinuous mode, where the transmitter part can be shut down on a regular basis in order to reduce power consumption. Low power consumption is an important parameter for a G.fast transceiver, which can be powered via reverse power feeding, i.e. extracting power from user via copper pair.

Regular disabling or enabling, i.e. powering down or up of the transmitter of a G.fast transceiver has impact on the crosstalk channel transfer function between other ports. Indeed, a change in termination impedance on one of the pairs in a binder can create sudden changes in the crosstalk transfer function between other pairs, in particular at frequencies in the transmission band of a G.fast transmitter (up to 212MHz). These fast transients in the crosstalk channel need to be tracked fast and accurately in order to maintain signal-to-noise ratio (SNR), which means complex crosstalk cancellation algorithms and computation resources are required.

### Summary

The object of embodiments of the invention is to provide transmit circuitry and a transmit method providing a simple solution to the problem of crosstalk variations when a transmit circuitry switches between a power-up mode and a power-down mode.

According to a first aspect of the invention there is provided a transmit circuitry for transmitting data between a distribution point unit and an end-user device, i.e. from a distribution point unit to an end-user device, or from an end-user device to a distribution point unit. The transmit circuitry comprises a line driver, an input and a controllable impedance regulator. The line driver is configured for amplifying a data signal to be transmitted over a copper pair between the distribution point unit and the end-user device. The input is arranged for receiving a signal for setting the line driver in a power-up mode or a power-down mode. The controllable impedance regulator is adapted for regulating an output impedance of the transmit circuitry seen by the copper pair and is further arranged for being controlled by the input in order to regulate the output impedance when the line driver is in the power-down mode.

Embodiments of the invention are based *inter alia* on the insight that, in order to reduce or avoid a sudden change in the crosstalk transfer function between copper pairs when switching between modes, it is desirable to keep the output impedance of the transmit circuitry, i.e. the impedance seen by the copper pair looking in the direction of the transmit circuitry, more or less constant in all modes, i.e. in the power-up mode and power-down mode. By adding a controllable impedance regulator to the transmit circuitry this can be achieved.

Preferably, the controllable impedance regulator is configured to regulate the output impedance of the transmit circuitry, when the line driver is in the power-down mode, to a value which is lower than the value of the power-down mode line driver output impedance, wherein the power-down mode line driver output impedance is the impedance of the line driver seen by the copper pair when the line driver is in the power-down mode in the non-active state of the controllable impedance. In other words the controllable impedance regulator is configured to lower the output impedance of the transmit circuitry compared to a transmit circuitry where the controllable impedance regulator is omitted, when the line driver is in the power-down mode. Prior art line drivers have a high output impedance when in the power-down mode. By adding such a controllable impedance regulator this value can be lowered so that it approximates the power-up output impedance of a line driver which is typically low. More in particular the controllable impedance regulator may be arranged for short-circuiting the power-down mode line driver output impedance, when the line driver is in the power-down mode.

In a preferred embodiment the line driver has a power-up mode line driver output impedance seen by the copper pair when the line driver is in the power-up mode, and the controllable impedance regulator is further configured for being controlled by said input, when the line driver is in the power-down mode, in order to set the output impedance of the transmit circuitry to a value which lies in a range between 50% and 150% of the value of the power-up mode line driver output impedance, in a frequency range between 10 MHz and 212 MHz, preferably in a range between 75% and 125% of the value of the power-up mode line driver output impedance.

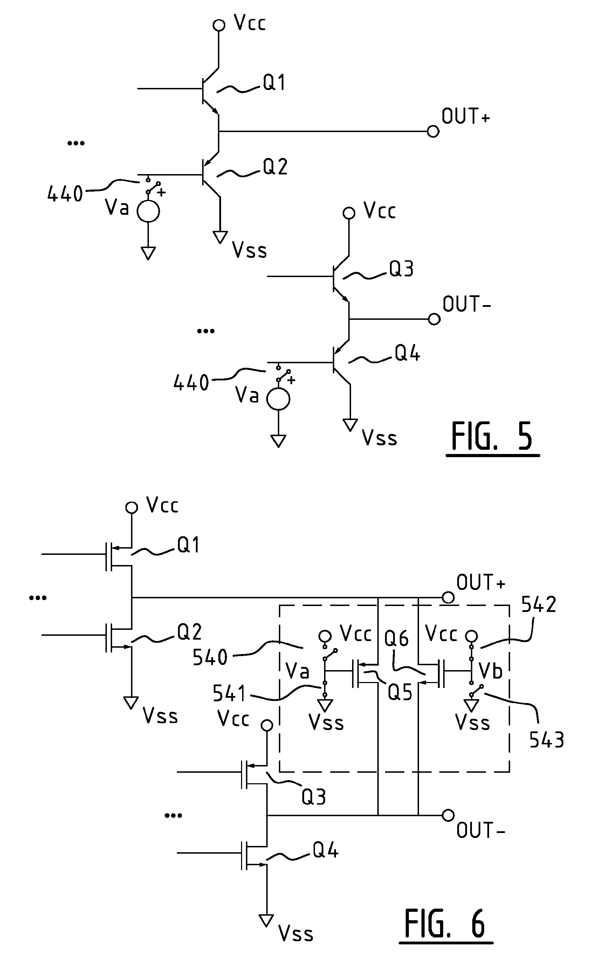

In a preferred embodiment the controllable impedance regulator comprises at least one switch arranged for being switched by the input when changing from the power-up mode to the power-down mode and when changing from the power-down mode to the power-up mode. This at least one switch may be implemented as one or more discrete components or as one or more integrated components. In a preferred embodiment the at least one switch may be integrated in the line driver. In a possible embodiment a first impedance is arranged between a first output of the line driver and a first copper line of the copper pair and/or a second impedance is arranged between a second output of the line driver and a second copper line of said copper pair. In such an embodiment the impedance regulator may be arranged directly (see e.g. the embodiment of figure 6) or indirectly (see e.g. the embodiment of figure 5) between the first and the second output.

In a possible embodiment the transmit circuitry further comprises a power supply regulator configured for setting the line driver in the power-up mode or the power-down mode, wherein the power supply regulator is arranged for being controlled by said input. The power supply regulator may comprise at least one switch. The function of the power supply regulator is to power down most internal functions of the line driver such that the line driver is consuming minimal power when there is no data to be transmitted. Also, the line driver may comprise a line adaption unit comprising a hybrid for coupling the line driver to the copper pair and the copper pair to receiver circuitry. Further, the transmit circuitry may comprise a digital signal processor for processing data to be transmitted, a digital to analogue converter, and a transmit filter between the digital to analogue converter and the line driver.

In a further developed embodiment the transmit circuitry further comprises a legacy controller configured for disabling the controllable impedance regulator in a legacy mode such that the regulating of the output impedance when the line driver is in the power-down mode, is disabled. Such a legacy mode may be useful when the transmit circuitry need to be installed on a copper pair connected to a legacy xDSL CPE. More in particular, this can facilitate specific G.fast migration scenario's where a G.fast DPU in legacy mode is connected to an existing copper line in parallel with a legacy xDSL service. This additional load should be seen as a high (linear) impedance load for legacy xDSL service.

According to another aspect of the invention there is provided a distribution point unit comprising any one of the embodiments of the transmit circuitry disclosed above.

According to yet another aspect of the invention there is provided an end-user device comprising any one of the embodiments of the transmit circuitry disclosed above.

According to a further aspect of the invention there is provided a method for transmitting data between a distribution point unit and an end-user device. The method comprises setting a line driver in a power-up mode, and transmitting data in said power-up mode over a copper pair between said distribution point unit and said end-user device; setting said line driver in a power-down mode; and regulating an output impedance seen by the copper pair when the line driver is in the power-down mode.

In a preferred embodiment the regulating is performed in such a way that the output impedance is lower than the power-down mode output impedance of the line driver as seen by the copper pair without the regulating. More preferably, the regulating comprises regulating the output impedance such that the output impedance lies, for a frequency between 10 MHz and 212 MHz, in a range between 50% and 150% of the value of the power-up mode line driver output impedance, more preferably in a range between 75% and 125% of the value of the power-up mode line driver output impedance when the line driver is in the power-down mode. The power-up mode output impedance of the line driver is the impedance seen by the copper pair when the line driver is in the power-up mode. Typically, the value for the output impedance is frequency dependent. High crosstalk levels at high frequencies will require smaller differences between power-up and power-down output impedance of the line driver. At low frequencies (e.g. <10 MHz), crosstalk changes are relatively smaller and therefore a wider range could be tolerable.

In a possible embodiment the regulating of the output impedance comprises controlling at least one switch.

According to an aspect of the invention there is provided a transmit circuitry comprising a line driver with additional functionality to allow the line driver to have a low output impedance, e.g. at least a factor ten smaller than the impedance of the copper pair as seen by the line driver in a frequency range between 10 MHz and 212 MHz, such that changes in the crosstalk transfer function between G.fast ports can be prevented. Preferably the low impedance is implemented such that the linearity of the G.fast analogue front-end circuit is not reduced in the receiving direction, because this can reduce G.fast (receiver) performance when the transmitter of the associated G.fast port is in power-down.

### Brief description of the figures

The accompanying drawings are used to illustrate presently preferred non-limiting exemplary embodiments of devices of the present invention. The above and other advantages of the features and objects of the invention will become more apparent and the invention will be better understood from the following detailed description when read in conjunction with the accompanying drawings, in which:
Figures 1A and 1B illustrate schematically the problem solved by embodiments of the invention;
Figure 2 is a schematic diagram of an embodiment of a DPU in which the invention may be implemented;
Figure 3 is a schematic diagram illustrating an embodiment of a transmit circuitry according to the invention;
Figure 4 is a schematic diagram illustrating an embodiment of the method of the invention;
Figure 5 is a schematic diagram illustrating an embodiment of a transmit circuitry according to the invention implemented in bipolar technology;
Figure 6 is a schematic diagram illustrating an embodiment of a transmit circuitry according to the invention implemented in CMOS technology; and
Figure 7 is a schematic diagram illustrating an embodiment of a transmit circuitry according to the invention in a legacy mode.

### Description of embodiments

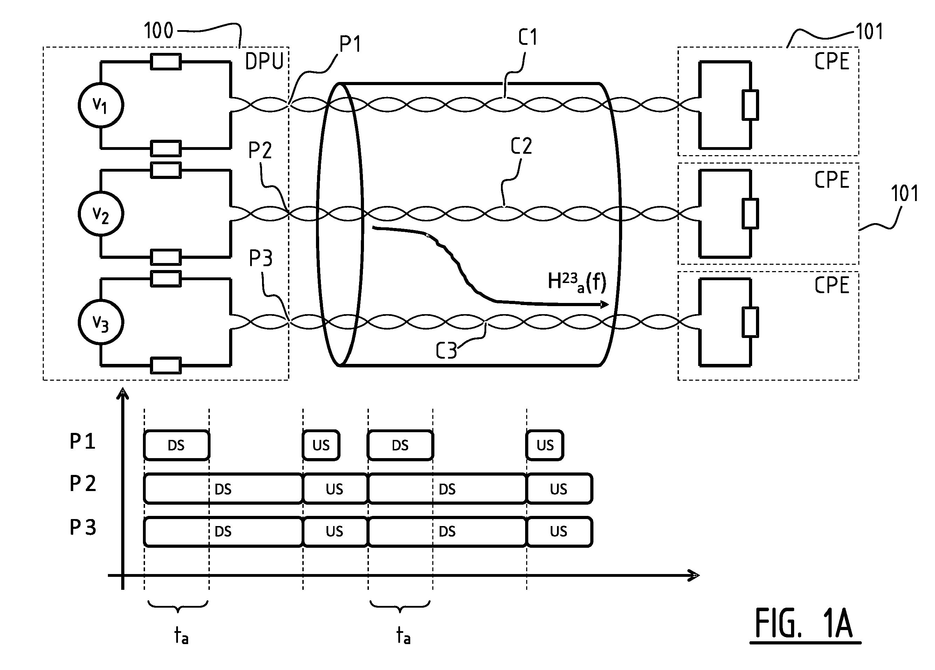

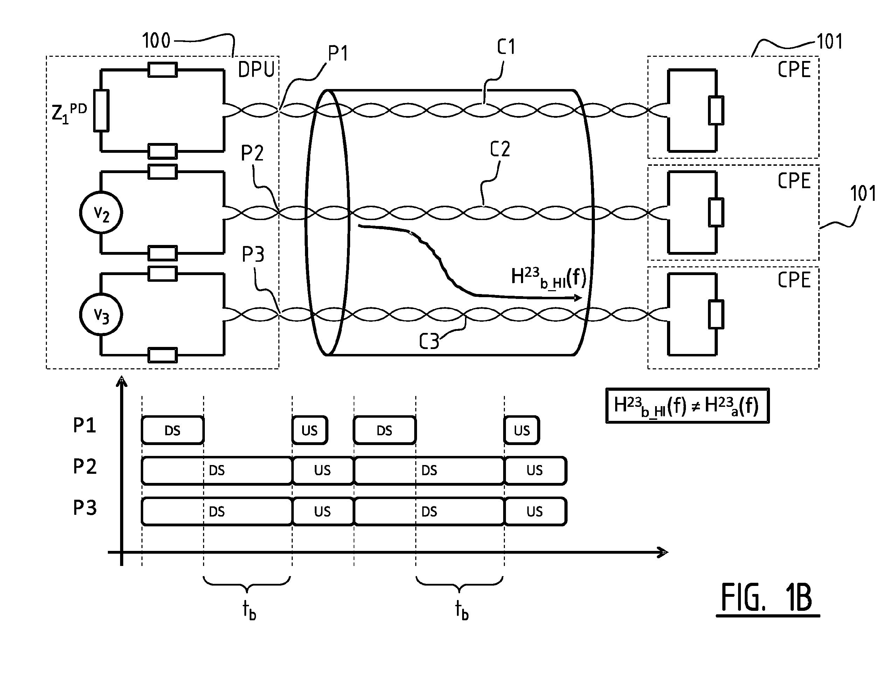

Figures 1A and 1B illustrate an exemplary configuration of a distribution point unit (DPU) 100 with three G.fast ports P1, P2, P3 communicating with three corresponding CPE's 101. It is assumed that port P1 is a user with low traffic and that port P2 and P3 are users with high traffic. Further, it is assumed that port P1 will shut down its transmitter V₁ between subsequent downstream time slots tₐ of port P1. In other words, during the time slots t_{b} (see figure 1B) the transmitter V₁ associated with port P1 is in a power-down mode, and during the downstream slots tₐ of port P1 the transmitter V₁ is in a power-up mode.

During the downstream transmitting periods tₐ of port P1, all transmitters of the three ports P1, P2, P3 are sending downstream power to the CPE's 101, which means that the line drivers of the three corresponding transmitters V₁, V₂, V₃ are powered up and active. The electrical Thevenin equivalent of an active line driver is ideally low impedance. In other words each copper pair C1, C2, C3 sees a specific impedance at the ports P1, P2 and P3, which is typically close to the characteristic impedance of the copper pair to avoid unwanted reflections.

The crosstalk channel transfer function H²³ₐ(f) (see figure 1A) expresses the coupling between port P2 and P3 during the period tₐ where all line drivers of the transmitters V₁, V₂, V₃ are powered up. In the next period t_{b} port P1 will shut down its transmitter V1. Default operation of a legacy (xDSL) line driver will result in that the equivalent output impedance of port P1 seen by the copper pair C1 is a high impedance, typically ranging from 400 Ohm to 1 kOhm, caused by powering down of the legacy line driver. Typically, this value is determined by external impedances, for instance gain resistors, etc. This high impedance is shown in figure 1B as Z₁^{PD}. The crosstalk channel transfer function between the two other active ports P2 and P3 will change due to the change of the output impedance of port P1. Indeed, the termination impedances seen by C1 in Figure 1A impacts the crosstalk channel between C2 and C3 due to the indirect coupling and C1 and C2 on one hand and C2 and C3 on the other hand. H²³_{b_HI}(f), see figure 1B, is the new crosstalk transfer function between port P2 and P3 during period t_{b}, when line driver of transmitter V₁ has a high output impedance due to power down mode of the transmitter V₁. It is expected that H²³_{b_HI}(f) will differ from H²³ₐ. This means that crosstalk cancellation algorithms would have to track these changes quickly and adapt the crosstalk coefficient accordingly in order to keep the SNR of P2 and P3 during downstream transmission slot t_{b} equal to the SNR of P2 and P3 during downstream time slot tₐ. An alternative would be to keep the transmitter of port P1 active during t_{b}, but this would result in higher power consumption of port P1.

Embodiments of the invention have as an object to provide a simple and robust mechanism allowing to reduce or eliminate crosstalk variations due to a transmitter switching from a power-up mode to a power-down mode and vice versa, whilst keeping the power consumption low. Embodiments of the invention are based on the insight that if port P1 would be disabled or shutdown in such a way that Z₁^{PD} would be low, the change in crosstalk coupling between port P2 and P3 between time periods tₐ and t_{b} could be minimized.

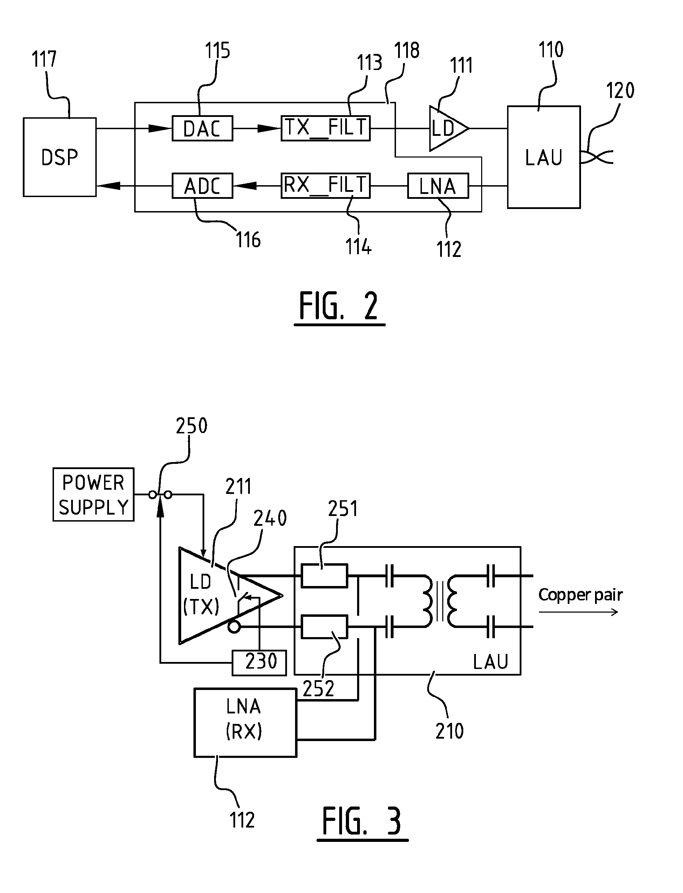

Figure 2 illustrates an exemplary configuration of typical transceiver circuitry of a DPU in which the invention may be implemented. Typically such transceiver circuitry is part of a Fast Transceiver Unit (FTU-x) comprising for each copper pair such transceiver circuitry. This may be an FTU-O for a DPU or an FTU-R for a CPE. The transceiver circuitry comprises a line driver (LD) 111 for amplifying a signal to be transmitted of the associated copper pair 120 and for driving the copper pair 120. The transceiver circuitry further comprises a line adaption unit (LAU) 110. The LAU 110 comprises a hybrid for coupling the line driver output to the copper pair and the copper pair to the low noise amplifier input, while achieving a low transmitter-receiver coupling ratio. The LAU 110 may further comprise additional filters and impedance matching circuitry. The transceiver circuitry comprises a digital signal processor 117 for processing the digital data to be transmitted as well as the received digital data, and an analogue front end (AFE) 118 comprising a digital to analogue converter (DAC) 115, a transmit filter 113 to reject the image after D/A conversion and to reduce noise, an analogue to digital converter (ADC) 116, a receiver filter 114, and a low noise amplifier (LNA) 112 for amplifying the receive signal with low noise.

Each DPU may further comprise a Vectoring Control Entity (VCE), a Timing Control Entity (TCE), and a Dynamic Resource Allocation (DRA) controller (not shown). The VCE is configured to control vectoring. Time division duplexing (TDD) frame synchronization between the copper pairs is controlled by the TCE. By default, the TCE aligns the start of the downstream transmission period or sub-frame for each line. The upstream/downstream (US/DS) split ratio is controlled by the Dynamic Resource Allocation (DRA) controller. This controller defines the amount of downstream and upstream time slots in the DS and US sub-frames. Whether for any given line the full sub-frame can be occupied by data symbols is also under control of the Dynamic Resource Allocation (DRA) controller. A detailed description of those components can be found in ITU, Telecommunication Standardization Sector, Temporary document 2013-09-Q4-R20R1, draft text for G.fast, see in particular figure 6.2 and the description of the components shown in that figure. This draft text for G.fast is included herein by reference. Typically, the TCE and the DRA are used to provide the transmit circuitry with a signal for setting the line driver in a power-up mode or a power-down mode, e.g. at the start of a downstream transmission session (tₐ) a power-up signal is provided to the transmit circuitry, while at the beginning of an interval (t_{b}) between a downstream and upstream transmission session a power-down signal is provided to the transmit circuitry.

Figure 3 illustrates a transceiver circuitry comprising an embodiment of a transmit circuitry according to the invention for transmitting data between a distribution point unit (DPU) and an end-user device, i.e. a CPE. Note that such transmit circuitry may be implemented in the DPU and/or in the CPE. The transmit circuitry comprises a line driver 211 configured for amplifying a data signal to be transmitted over a copper pair between the DPU and the CPE; an input 230 for receiving a signal for setting the line driver in a power-up mode or a power-down mode; and a controllable impedance regulator 240, here represented as a switch, adapted for modifying an output impedance of the transmit circuitry seen by the copper pair. The controllable impedance regulator 240 is arranged for being controlled by the input 230 in order to regulate the output impedance when the line driver is in the power-down mode. In the illustrated exemplary schematic embodiment the input 230 controls a first power supply switch 250 for controlling the supply of power to the line driver such that power is supplied to the line driver 211 in a power-up mode and that minimal power is consumed by the line driver 211 in a power-down mode. The input 230 also controls the switch 240 which is arranged close to the output stage of the line driver 211. The control is such that the switch 240 is open in power-up mode, and does not significantly influence the power-up mode output impedance, and that the switch 240 is closed in power-down mode in order to ensure that the output impedance remains low, preferably similar to the power-up mode output impedance. Preferably, the external or internal switch 240 is implemented such that it does not create additional distortion products when the CPE is transmitting upstream power.

If it is assumed that the line driver 211 without the switch 240 has a power-down mode line driver output impedance seen by the copper pair when the line driver is in the power-down mode, then the controllable switch 240 is arranged to regulate the output impedance of the transmit circuitry to a value which is lower than the value of this power-down mode line driver output impedance (without the switch 240). Preferably the line driver 211 has a power-up mode line driver output impedance seen by the copper pair when the line driver is in the power-up mode, and the controllable switch 240 is further configured for setting the output impedance of the transmit circuitry, when the line driver is in the power-down mode, to a value which lies in a range between 50% and 150% of the value of said power-up mode line driver output impedance, in a frequency range between 10 MHz and 212 MHz.

In the illustrated embodiment a first impedance 251, e.g. 50 Ohm, is arranged between a first output of the line driver 211 and a first copper line of the copper pair, and a second impedance 252, e.g. 50 Ohm, is arranged between a second output of the line driver 211 and a second copper line of the copper pair. The controllable switch 240 may be arranged between the first and the second output of the line driver 211.

The transceiver circuitry of figure 3 further comprises a low noise amplifier 112. The transceiver circuitry of figure 3 may be combined with a digital signal processor and an analogue front end as in the example of figure 2.

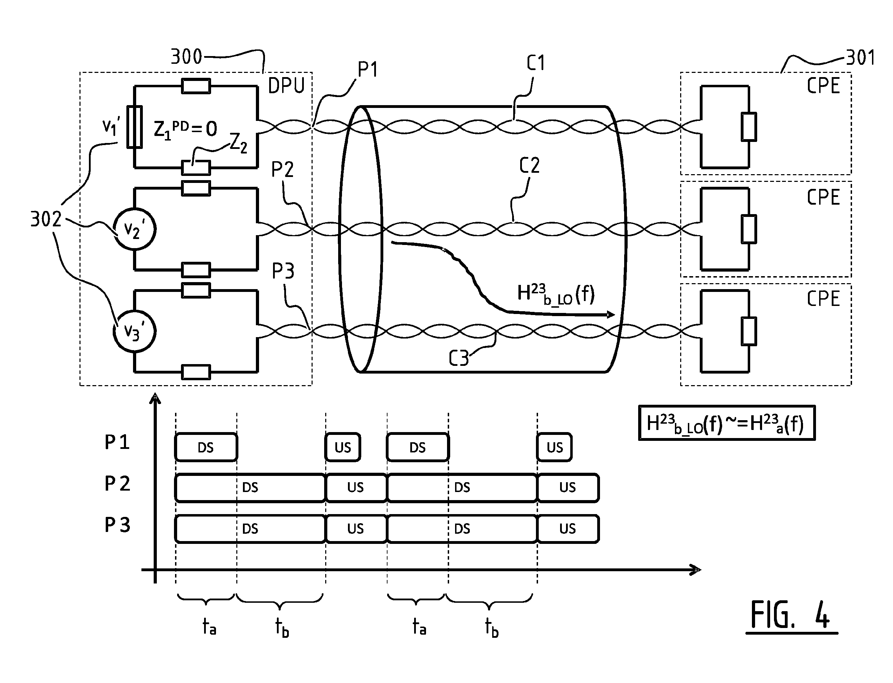

Now an embodiment of the method of the invention for transmitting data between a distribution point unit (DPU) 300 and a number of CPE's 301 will be illustrated referring to figure 4. The DPU 300 comprises transmit circuitry 302 for each copper pair C1, C2, C3 which may be implemented as in figure 3. In a first step the situation is as in figure 1A where the line driver of the first transmitter V'₁ is in a power-up mode, and data is transmitted in said power-up mode over the copper pair C1. When the line driver of the first transmitter V'₁ is set in a power-down mode, the output impedance seen by the copper pair C1 is regulated in such a way that the output impedance remains close to the value of V'₁ in power-up mode, e.g. by closing a switch as in the embodiment of figure 3.

It is assumed that the crosstalk channel transfer function H²³ₐ(f) expresses the coupling between port P2 and P3 during the period tₐ where all line drivers of the transmitters V'₁, V'₂, V'₃ are powered up, and that in the period t_{b} port P1 will shut down its transmitter V'₁. In embodiments of the invention, instead of seeing a high output impedance at port P1, the sum of the impedances Z₁ and Z₂ is seen, see figure 4, as Z₁^{PD} will be approximately zero. Hence, the crosstalk channel transfer function H²³_{b_HI} (f) between the two other active ports P2 and P3 will not change significantly. H²³_{b_HI} (f) will be approximately equal to H²³ₐ. In that way complex crosstalk cancellation algorithms can be avoided whilst allowing a transmitter to be in a power-down mode when not transmitting.

In the above disclosed embodiments, the focus has been put on transmit circuitry in the DPU, but the skilled person understands that the same or similar transmit circuitry may be used in the CPE's.

Figure 5 illustrates an embodiment of a transmit circuitry according to the invention implemented in bipolar technology. A typical output stage of a line driver in bipolar technology comprises a first complementary output pair Q1, Q2 generating the positive output OUT+ of the line driver, and a second complementary output pair Q3, Q4 generating the negative output OUT- of the line driver. When the line driver is put in a power-down mode, in prior art embodiments almost all components of the line driver are powered down. According to embodiments of the invention a voltage Va may be applied on the base of Q2 and Q4 when the line driver is in power-down mode, in order to turn on the bipolar transistors Q2 and Q4. This may be realized through switches 440 which are closed when the line driver is put in a power-down mode and opened when the line driver is put in a power-up mode. By turning on Q2 and Q4, i.e. by closing switches 440, OUT+ and OUT- are connected through a low impedance between the collector and emitter of Q2 to VSS and through a low impedance between the collector and emitter of Q4 to VSS. Hence, OUT+ and OUT- are shorted from an AC point of view.

Figure 6 illustrates an embodiment of a transmit circuitry according to the invention implemented in CMOS technology. A typical output stage of a line driver in CMOS technology comprises a first complementary output pair Q1, Q2 generating the positive output OUT+ of the line driver, and a second complementary output pair Q3, Q4 generating the negative output OUT- of the line driver. When the line driver is put in a power-down mode, almost all components of the line driver are powered down. According to embodiments of the invention an additional NMOS Q6 and PMOS Q5 may be added between OUT+ and OUT-. By applying either Vcc or Vss on the gate of Q5 and Q6 (see voltages Va and Vb) in accordance with the table below, OUT+ may be shorted to OUT-when the line driver is in the power-down mode.

| Mode line driver | Va | Vb |
|---|---|---|
| Power-up | Vcc | Vss |
| Power-down | Vss | Vcc |

This may be realized through switches 540, 541, 542, 544 as will be immediately apparent to the skilled person. By closing switches 541 and 542, Q5 and Q6 are turned on so that OUT+ and OUT- are connected through a low impedance.

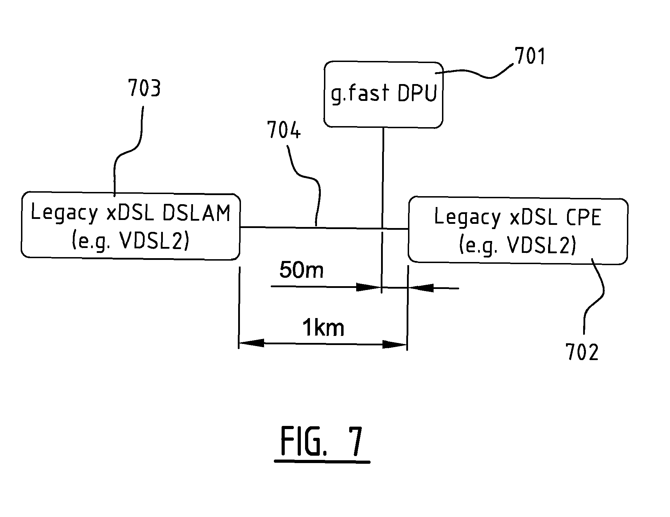

In a further developed embodiment the transmit circuitry may comprise a legacy controller configured for disabling the controllable impedance regulator in a legacy mode such that said setting of the output impedance when the line driver is in the power-down mode, is disabled. In other words, by providing such a legacy mode two power-down modes are allowed: a low impedance power-down mode (as described in previous figures) and a high impedance power-down mode which is the default mode for xDSL legacy line drivers. In that way a G.fast DPU 701 may be pre-installed in the high impedance power-down mode and connected to the xDSL copper line 704 in parallel with a legacy xDSL service 702, 703, see figure 7 without the need for additional switches in the copper pair. In this mode, the G.fast DPU 701 (pre-installed, high impedance power-down mode) acts as a high impedance (linear) load seen from the xDSL legacy CPE 702 such that the CPE transmitting and hybrid rejection are not distorted. In an alternative embodiment a G.fast DPU according to an embodiment of the invention but without a legacy mode may be used in parallel with a legacy service, connected in parallel to the same copper pair. A switch may be included between the G.fast DPU and the copper line 704 in order to switch a user from a legacy service (e.g. VDSL2) to a new service from the DPU (e.g. G.fast). However, this would add additional complexity during installation.

Although the focus has been put on G.fast, the skilled person understands that embodiments of the invention are applicable both on VDSL and G.fast. Embodiments of the invention have more benefits for G.fast because of the higher crosstalk and discontinuous operation, but the same principles can be used in VDSL to reduce crosstalk changes due to disorderly leaving, ports starting up etc.

Whilst the principles of the invention have been set out above in connection with specific embodiments, it is to be understood that this description is merely made by way of example and not as a limitation of the scope of protection which is determined by the appended claims.

## Claims

1. A transmit circuitry for transmitting data between a distribution point unit and an end-user device, comprising:
- a line driver configured for amplifying a data signal to be transmitted over a copper pair between said distribution point unit and said end-user device;
- an input for receiving a signal for setting said line driver in a power-up mode or a power-down mode;
- a controllable impedance regulator adapted for regulating an output impedance of the transmit circuitry seen by the copper pair; wherein said controllable impedance regulator is further arranged for being controlled by said input in order to regulate said output impedance when the line driver is in the power-down mode.

2. The transmit circuitry of claim 1, wherein said line driver has a power-down mode line driver output impedance seen by the copper pair when the line driver is in the power-down mode; and said controllable impedance regulator is configured to regulate the output impedance of the transmit circuitry, when the line driver is in the power-down mode, to a value which is lower than the value of the power-down mode line driver output impedance.

3. The transmit circuitry of claim 1 or 2, wherein said line driver has a power-up mode line driver output impedance seen by the copper pair when the line driver is in the power-up mode, wherein said controllable impedance regulator is further configured for being controlled by said input, when the line driver is in the power-down mode, in order to set the output impedance of the transmit circuitry to a value which lies in a range between 50% and 150% of the value of said power-up mode line driver output impedance, in a frequency range between 10 MHz and 212 MHz.

4. The transmit circuitry of any one of the previous claims, wherein said line driver has a power-down mode line driver output impedance seen by the copper pair when the line driver is in the power-down mode; and said controllable impedance regulator is arranged for short-circuiting said power-down mode line driver output impedance, when the line driver is in the power-down mode.

5. The transmit circuitry of any one of the previous claims, wherein said controllable impedance regulator comprises at least one switch arranged for being switched by the input when changing from the power-up mode to the power-down mode and when changing from the power-down mode to the power-up mode.

6. The transmit circuitry of any one of the previous claims, further comprising a first impedance having one end connected to a first output of the line driver and another end intended for being connected to the first copper line of the copper pair, and/or a second impedance having one end connected to a second output of the line driver and another end to a second copper line of said copper pair, said impedance regulator being arranged between said first and said second output.

7. The transmit circuitry of any one of the previous claims, further comprising a power supply regulator configured for setting the line driver in the power-up mode or the power-down mode; wherein said power supply regulator is arranged for being controlled by said input.

8. The transmit circuitry of any one of the previous claims, further comprising a legacy controller configured for disabling the controllable impedance regulator in a legacy mode such that said regulating of the output impedance when the line driver is in the power-down mode, is disabled.

9. The transmit circuitry of any one of the previous claims, further comprising a line adaption unit comprising a hybrid for coupling the line driver to the copper pair and the copper pair to receiver circuitry.

10. Distribution point unit comprising the transmit circuitry as claimed in any one of the previous claims.

11. End-user device comprising the transmit circuitry as claimed in any one of the claims 1-9.

12. A method for transmitting data between a distribution point unit and an end-user device, comprising:
- setting a line driver in a power-up mode, and transmitting data in said power-up mode over a copper pair between said distribution point unit and said end-user device;
- setting said line driver in a power-down mode;
- regulating an output impedance seen by the copper pair when the line driver is in the power-down mode.

13. The method of claim 12, said line driver having a power-down mode output impedance seen by the copper pair without said regulating; wherein said regulating is such that said output impedance is lower than said power-down mode output impedance of said line driver.

14. The method of claim 12 or 13, wherein said line driver has a power-up mode output impedance seen by the copper pair when the line driver is in the power-up mode, wherein said regulating comprises regulating the output impedance such that the output impedance lies in a range 50% and 150% of the value of said power-up mode line driver output impedance, in a frequency range between 10 MHz and 212 MHz, when the line driver is in the power-down mode.

15. The method of any one of the claim 12-14, wherein regulating said output impedance comprises controlling at least one switch.
